Europäisches Patentamt

European Patent Office

Office européen des brevets

(19)

(11) Publication number: **0 138 718**
**B1**

(12) # EUROPEAN PATENT SPECIFICATION

(45) Date of publication of patent specification: **09.09.87**

(51) Int. Cl.⁴: **B 67 D 5/54**

(21) Application number: **84402079.2**

(22) Date of filing: **16.10.84**

(54) Method and apparatus for feeding drug liquid from hermetic returnable can.

(30) Priority: **17.10.83 JP 192514/83**
**17.10.83 JP 192515/83**

(43) Date of publication of application:
**24.04.85 Bulletin 85/17**

(45) Publication of the grant of the patent:
**09.09.87 Bulletin 87/37**

(84) Designated Contracting States:
**DE FR GB**

(56) References cited:
**DE-A-2 535 182**
**FR-A-2 035 598**
**US-A-3 535 124**
**US-A-3 909 205**

(73) Proprietor: **NIPPON ZEON CO., LTD.**
**6-1, 2-chome**
**Marunouchi Chiyoda-ku, Tokyo (JP)**

(73) Proprietor: **FUJITSU LIMITED**
**1015, Kamikodanaka Nakahara-ku**
**Kawasaki-shi Kanagawa 211 (JP)**

(72) Inventor: **Yamazaki, Masahiro**
**1419-8, Hakusancho Midori-ku**
**Yokohama-shi Kanagawa-ken (JP)**
Inventor: **Iizuka, Shigeru**
**2211-25, Kamigocho Totsuka-ku**
**Yokohama-shi Kanagawa-ken (JP)**
Inventor: **Kamiya, Shigemitsu**
**1458-1, Miyamaedaira Kawasaki-ku**
**Kawasaki-shi Kanagawa-ken (JP)**
Inventor: **Oka, Yoshiro**
**873, Futoocho Kohoku-ku**
**Yokohama-shi Kanagawa-ken (JP)**
Inventor: **Fujino, Katsuhiro**
**83-3, Nishihassakumachi Midori-ku**
**Yokohama-shi Kanagawa-ken (JP)**

(74) Representative: **Schrimpf, Robert et al**
**Cabinet Regimbeau 26, Avenue Kléber**
**F-75116 Paris (FR)**

Courier Press, Leamington Spa, England.

# Description

## BACKGROUND OF THE INVENTION

### (1) *Field of the Invention*

The present invention relates to a method for feeding a variety of drug liquids used in a drug liquid treatment process for electronic materials such as semiconductors and precision machinery components, and a feeding monitor apparatus. More specifically, it relates to a method for stably feeding the drug liquid while detecting its amount, in the case that the drug liquid is fed from the liquid-filled hermetic returnable can to the drug liquid treatment process, and a feeding monitor apparatus connected to the returnable can.

### (2) *Description of the Prior Art*

The progress of fine working techniques in the fields of integrated circuits, transistors and the like is remarkable, and the quality control of drug liquids used in manufacturing them is now getting rather severe. Particularly, the inclusion of fine particle contaminants into the drug liquid must be prevented, since such an inclusion has a direct influence on a yield of the products. For this reason, the liquid is usually precisely filtered, and clean containers are filled with the filtered liquid in a purified environment (in a clean room) in order to manufacture articles. As the containers, about 1 to 8-liter glass bottles are generally employed.

The operation of filling the glass bottles with the drug liquid is carried out in a clean room but under opened circumstances. Therefore, the incorporation of dust, contaminants and the like into the drug liquid is inevitable, though its degree is not so bad as in the atmosphere. Further, the containers which are the glass bottles are disadvantageously liable to break in the course of transport and distribution steps, and disposal of the used empty containers is also burdonsome, since they are disposable.

On the side of users of the drug liquid, it is also troublesome to open the glass bottle and to transfuse the drug liquid therein into another container for a device on a manufacturing line such as an integrated circuit, and at this time, dust and contaminants would get into the contents purified by the precision filtration. In extreme cases, the contents would be spilled and overflowed.

It is known (publication US—A—3 909 205) to feed a liquid from a hermetic liquid can to a liquid outlet, by providing said can with means for introducing a liquid surface pressurizing gaz thereinto, by disposing a monitor tank between said can and said outlet, and by transporting said liquid from said can to said tank by the use of said gaz, while monitoring a level position of the liquid in the tank.

However, such device is not intended to be used with a returnable drug iquid can and is not designed to make the can easily exchangeable for a new one during the feeding of the liquid from the monitor tank to the outlet.

In view of such inconveniences, the inventors of the present invention have developed a returnable can, i.e. a receiving container, for the drug liquid, which can easily be connected to a pipe in the drug liquid treatment process without opening the returnable can and without transfusing the liquid therein into another container each time it is used and by which the above-mentioned drawbacks are overcome.

This receiving container is constituted so that the drug liquid therein may be fed to a semiconductor-manufacturing device by utilizing a gas pressure, as disclosed in Japanese Patent Provisional Publication No. 21021/1984.

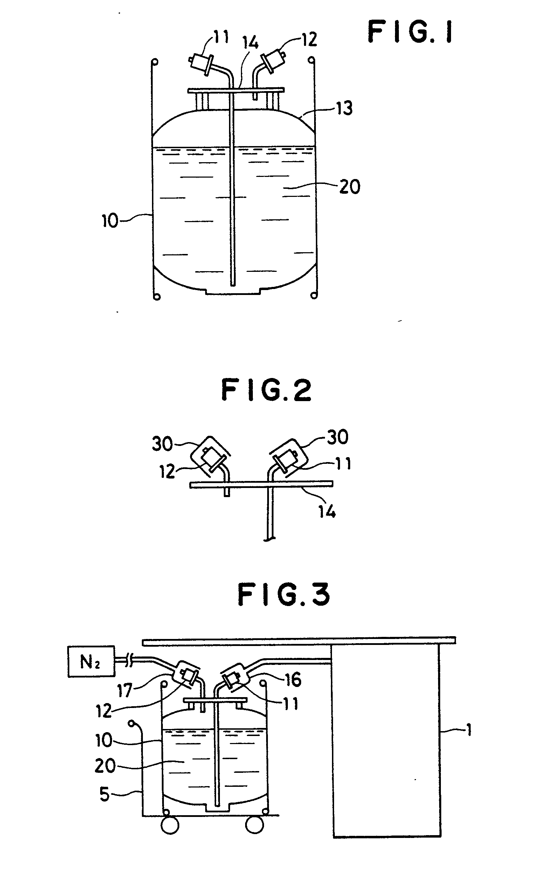

Figures 1 to 3 attached hereto show this receiving container and an arrangement in which the receiving container is connected to the semiconductor-manufacturing device.

As shown in Figure 1, a canister 10 which is a returnable can including a drug liquid 20 is composed of a liquid-receiving container body 13 and a flange 14, which is provided with a coupler 11 for allowing the liquid to be transported therethrough and a male coupler 12 for allowing a gas to pass therethrough. These couplers 11, 12 are protected by caps 30.

In the case that the returnable can is connected to a semiconductor-manufacturing device 1, a purified nitrogen gas is fed to the canister 10 through couplers 17, 12 and the drug liquid 20 is delivered to the device 1 through the couplers 16, 11 by virtue of the nitrogen gas pressure, as exhibited in Figure 3.

Such a returnable can may receive a more amount of the drug liquid than a conventional glass bottle, but the volume of the drug liquid cannot be monitored, depending on a material used for the returnable can. Further, since the much amount of the drug liquid is received therein, it is difficult to always monitor its remaining volume and to make the exchange of the depleted bottle for a new one at a good timing, and if a worker is not conscious of its absence in the bottle and if a drug liquid treating device continues to drive, untreated infererior goods will be manufactured. Even if a metering instrument, for detecting a decreasing state of the liquid, such as an integrating flowmeter is mounted on the semiconductor-manufacturing device, it will be exceedingly difficult to automatically exchange the empty returnable can for a new one.

## SUMMARY OF THE INVENTION

The present invention provides a method and an apparatus according to claims 1 and 3 respectively by which the above-mentioned drawbacks can be overcome; a drug liquid can be fed, monitoring its volume without bringing the liquid into contact with the outside air, while keeping up its clean state; when the volume of the drug liquid decreases below a predetermined level, warning will be given; and even during the exchange of the empty returnable can for a new one, the drug liquid can successively be fed without halting a drug liquid treating device.

According to the present invention having the above-mentioned object, the drug liquid is delivered from a hermetic returnable can by means of a liquid surface-pressurizing system, and for this purpose, a liquid level monitor tank is interposed between the hermetic returnable can and a drug treatment process. The liquid is transported through this monitor tank, and after the returnable can is empty, the liquid in this monitor tank is used and when the level of the liquid in the monitor tank reaches a predetermined position, warning will be given to attract the attention of the exchange of the returnable cans. Further, a pipe between the returnable can and the monitor tank is adapted to be shut off so that a liquid surface-pressurizing gas may be introduced into the monitor tank even during the exchange of the returnable cans to pressurize the surface of the liquid in the monitor tank and to thereby continue the feeding of the drug liquid to the process. By virtue of the above-mentioned constitution, the feeding of the drug liquid is feasible, even while the drug liquid is freshly delivered from the new returnable can to the monitor tank. In short, by connecting, to the monitor tank, a source of the gas for pressurizing the surface of the liquid in the returnable can, the monitor tank is caused to possess a role as a warning instrument and a function as a cushion tank at the time of the exchange of the cans.·

The present invention is also concerned with an apparatus which comprises a monitor tank disposed between a hermetic returnable can and a drug liquid treatment process, a means for delivering the drug liquid in the hermetic returnable can to the drug liquid treatment process through the monitor tank by a liquid surface-pressurizing system, a means for detecting a volume of the drug liquid in the hermetic returnable can from a liquid level of the drug liquid in the monitor tank and for warning an exchange time of the hermetic returnable can, a means for continuing the delivery of the drug liquid to the drug liquid treatment process by the use of the drug liquid in the monitor tank, whereby the drug liquid is successively fed from the hermetic returnable can to an optional device for accomplishing a drug liquid treatment process.

## BRIEF DESCRIPTION OF THE DRAWINGS

Figure 1 is a schematic elevational view of a known hermetic returnable can used in the present invention;

Figure 2 is an elevational view showing a flange and couplers attached to the returnable can body;

Figure 3 is an illustrative view showing schematically a known connection means between the returnable can and a manufacturing device;

Figure 4 is a schematic sectional elevation of an apparatus by which a drug liquid feeding method of the present invention is carried out;

Figure 5 is a partially sectional elevation of the upper portion of a monitor tank;

Figure 6 is a plan view of the upper portion of the monitor tank;

Figures 7 to 9 are schematically illustrative views to elucidate the drug liquid feeding method of the present invention; and

Figure 10 is a schematic sectional elevation showing another embodiment of the apparatus according to the present invention.

## DETAILED DESCRIPTION OF THE INVENTION

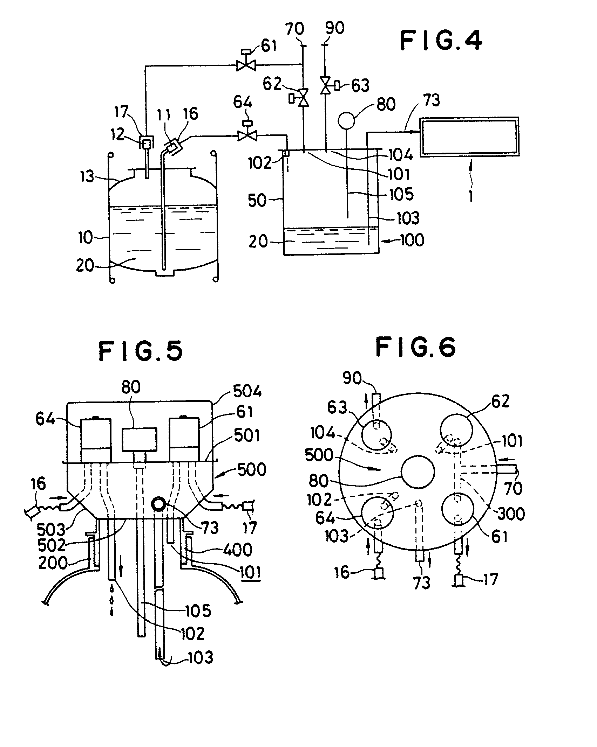

The present invention will be described in detail in reference to embodiments shown by Figures 4 to 10. It is to be noted that a hermetic returnable can, couplers, a manufacturing machine and the like will be represented by the same reference numerals as in Figures 1 to 3.

A drug liquid feeding monitor apparatus 100 used in the present invention comprises a monitor tank 50 for receiving a predetermined amount of a drug liquid 20, a level gauge 80 for detecting a level position of the drug liquid in the monitor tank 50, a connecting hole 70 of a pipe for introducing a gas which applies a pressure in order to feed the drug liquid during a certain period of time, a connection hole 90 of a pipe for discharging a gas (nitrogen) present in the tank, electromagnetic valves 61, 62, 63, 64 for switching circuits of the nitrogen gas and the drug liquid, female couplers 17, 16 for connecting the monitor apparatus to a canister 10 which is a returnable can, a connection hole 73 of a pipe for feeding the drug liquid to a semiconductor-manufacturing device 1, flow circuit pipes for the nitrogen gas and the drug liquid, circuits for feeding electric power to the electromagnetic valves 61, 62, 63, 64 and the level gauge 80, an operation switch on an dashboard (not shown), and a circuit for feeding electric power for display.

The principle of the apparatus of the present invention is as follows: By virtue of the pressure of the nitrogen gas, the drug liquid in the canister 10 is fed to the monitor tank 50 of the apparatus, and the liquid is maintained within a predetermined amount by detecting the liquid level with the aid of the level gauge 80 and the drug liquid is delivered from the monitor tank 50 to the device 1. Further, when the amount of the drug liquid decreases by using it and the canister 10 becomes empty, and when the level of the liquid in the monitor tank 50 is below a predetermined position, the level gauge 80 detects this fact and gives the alarm, whereby a worker is conscious that the canister 10 is empty and exchanges the empty one for a new one. Another feature of the present invention permits continuing to drive the semiconductor-manufacturing device 1 even during the exchange of the canisters.

Concretely, the above-mentioned electromagnetic valves 61, 62, 63, 64 and a head of the level gauge 80 are mounted on a seating plate 501 of a pedestal 500 which is disposed on the monitor tank 50.

The above-mentioned pedestal 500 has the shape of a substantially inverted truncated cone, and is adapted to be detachably coupled to the monitor tank 50 by screwing an external thread 400 of the pedestal 500 into an internal thread 200 inside the neck portion of the monitor tank 50. Therefore, the pedestal 500 and the monitor tank 50 are airtightly linked to each other.

The pedestal 500 is covered with a hood 504 to protect the electromagnetic valves and the level gauge. A pipe for receiving the drug liquid from the returnable can extends from the outside to the inside of the monitor tank 50 through a slanting side wall 503 of the pedestal 500, the electromagnetic valve 64 and the pedestal 500, the abovementioned pedestal 500 being disposed between the seating plate 501 and a lower partition plate 502 of the pedestal 500. The above pipe is provided, on its one free end outside the monitor tank 50, with one connection hole having the coupler 16 and is provided, on its another free end inside the monitor tank 50, with another connection hole 102. A pipe for delivering the drug liquid extends from the bottom portion in the monitor tank 50 to the outside of the tank 50 through the partition plate and the side wall, and the pipe has an opening 103 at its one free end inside the monitor tank 50 and a connection hole 73 at its another free end outside the tank 50. A pipe for introducing a pressurized air extends from the outside to the inside of the pedestal 500 and branches into two passages therein, one of which extends therefrom to the outside of the pedestal 500 through the electromagnetic valve 61 and the side wall 503 and another of which extends therefrom to the inside of the monitor tank 50 thorugh the electromagnetic valve 62 and the lower partition plate. The branched pipes have the coupler 17 at its one free end outside the monitor tank 50 and have a connection hole 101 at its another free end inside the monitor tank 50. The gas in the tank is discharged from a connection hole 104 through the bottom partition plate, the electromagnetic valve 63, the side wall 503 and the connection hole 90. A detecting portion 105 of the level gauge 80 is inserted into the monitor tank 50 through the lower partition plate 502.

According to the monitor apparatus constituted as described above, the connections of the respective pipes are all carried out through the side wall of the pedestal, therefore a less space is only taken and operation can be done very conveniently. Further, the connection with a nitrogen source is sufficiently accomplished at only one position, and since the feeding of the nitrogen gas to the canister and the handling of the valves are carried out on the monitor tank, these operations are fairly easy. Furthermore, the level gauge and the electromagnetic valves are mounted all together on the pedestal, accordingly check and maintenance can conveniently be carried out. Additionally, circuits connected to the dashboard (not shown) can also be arranged all together in order.

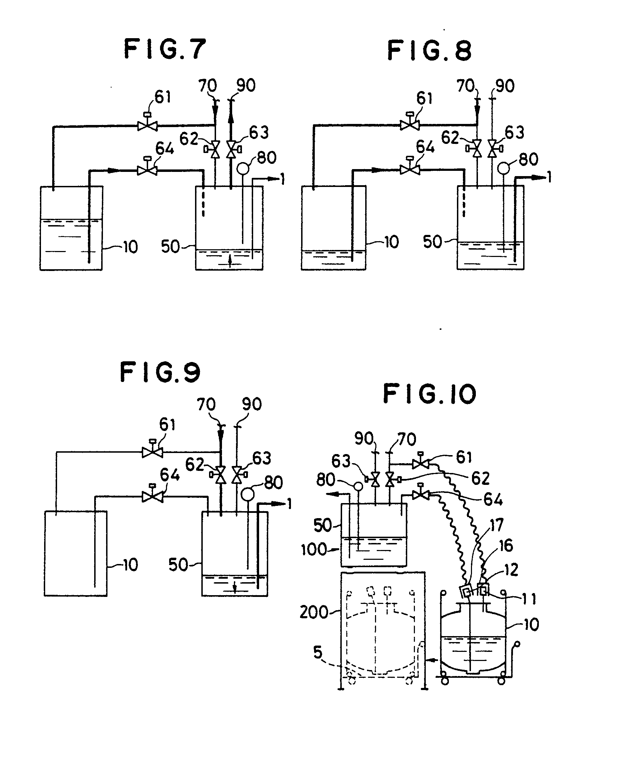

A method for feeding the drug liquid by the use of the above-mentioned apparatus will be described in detail in reference to Figures 7 to 9. Bold lines shown in these drawings mean established circuits.

The male couplers 12, 11 of the canister 10 are coupled to the female couplers 17, 16 of the apparatus 100. The purified nitrogen gas having 0.5 to 1.0 Kg/cm$^2$ gauge introduced through the connection hole 70. A desired electric power is fed (Figure 6).

A starting button (not shown) on the dashboard is pushed to start the operation of the apparatus. As shown in Figure 7, the level gauge 80 detects that the volume of the liquid in the monitor tank 50 is below a predetermined level, and then the electromagnetic valve 61 opens and the pressure is applied to the canister 10. Simultaneously, the electromagnetic valve 64 opens to make up the circuit of the drug liquid. Then, when the electromagnetic valve 63 on the pipe for discharging the gas in the tank opens, the drug liquid in the returnable can is automatically delivered to the monitor tank 50 with the aid of the pressure of the nitrogen gas (this condition is hereinafter referred to as "during filling").

When the level of the liquid in the monitor tank 50 reaches a predetermined position as shown in Figure 8, the level gauge detects this fact and the electromagnetic valve 63 and the connection hole 90 on the pipe for discharging the gas in the tank are closed. The level of the liquid in the tank rises till it is equivalent to the pressure of the nitrogen gas, and the introduction of the liquid thereinto stops. So long as the liquid is present in the canister 10, this state is retained as a steady state, and the use of the drug liquid is begun in the semiconductor-manufacturing device 1 (this state will be hereinafter referred to as "during using").

While the drug liquid is used in the device 1, the liquid in the canister 10 continuously runs into the monitor tank 50, and when the canister 10 is empty at last, the level of the liquid in the monitor tank 50 begins to lower. When the level of the liquid in the monitor tank goes down below a predetermined position, the level gauge 80 detects it, and the alarm is given and a sign appears on the dashboard (this state is hereinafter referred to as "empty").

Simultaneously, the electromagnetic valves 61, 64 close as shown in Figure 9 to cut off the circuit between the canister 10 and the monitor tank 50, and the electromagnetic valve 62 opens in order to allow the pressure of the nitrogen gas to be applied to the monitor tank 50, whereby the remaining liquid in the monitor tank 50 is ready to be used. Since the opened lower end of the pipe for feeding the drug liquid lies in the vicinity of the bottom of the monitor tank, the drug liquid can continuously be used so long as it is present therein.

In response to the alarm, a worker exchanges the empty canister for a new full canister while the remaining liquid still exists in the monitor tank 50.

Afterward, when a reset button (not shown) on the dashboard is pushed, the above-mentioned "during filling" state returns and the introduction of the drug liquid from the canister 10 into the monitor tank 50 begins. At this time, the electromagnetic valve 63 of the monitor tank 50 and the connection hole 90 of the gas (nitrogen) discharging pipe are opened, so that the pressure in the monitor tank 50 decreases. However, a flow rate of the gas through the connection hole 90 on the gas discharging pipe is adjusted by forming orifices or the like so that it may be smaller than a flow rate of the liquid which is introduced from the canister thereinto and so that the pressure in the monitor tank 50 may become a positive pressure to atmospheric pressure, a pipe resistance and a head difference. Therefore, even in the above-mentioned state, the successive use of the drug liquid is feasible in the semiconductor-manufacturing device 1.

Figure 10 shows another embodiment of the present invention, in which the canister 10 can be accommodated under a trestle 200 on which the apparatus 100 of the present invention is put. According to this embodiment, the occupied floor area can be diminished to obtain a compact structure, and the connecting operation can easily be carried out. In the convenient embodiment above, the canister 10 can be drawn from the receiving section under the trestle while laid on a cart 5, and after the completion of the coupler connections, the canister 10 can be pushed thereinto again by the utilization of the cart 5.

As understood from the above, the present invention is connected with the method for feeding the drug liquid and the apparatus for monitoring the feeding of the drug liquid in which the successful control of the pressure in the monitor tank 50 advantageously permits not only giving the alarm in response to the liquid volume but also using continuously the device even during the exchange of the canisters 10.

In view of the principle of the present invention, as the level gauge 80, for example, there may be employed an electrostatic capacity type level gauge, a float type level gauge, a phototube type level gauge or the like in compliance with its application field. Further, in place of the electric power, an air pressure driving system may be employed. The present invention does not put any restriction on the selection of such systems.

According to the principle of the present invention, when the rising level of the drug liquid in the monitor tank 50 reaches an equilibrium by virtue of the pressure in the monitor tank, the level gauge will give the alarm signal. Therefore, the one level gauge suffices to accomplish the function of detecting a predetermined level, but the two level gauges may also be employed to detect two points of a lower level and a higher level of the drug liquid.

Other various manners can be conceived, but in short, according to the present invention, the canister which is the returnable can is connected to the semiconductor-manufacturing device via the drug liquid feeding monitor apparatus in order to permit warning the absence of the drug liquid in the canister and the timing of exchanging the canisters, and feeding successively the drug liquid to the semiconductor-manufacturing device even during exchanging the canisters. Thus, the present invention is not limited at all by the detecting manner of the liquid level.

Materials used in the present invention include neither those which are corroded to produce a contaminant such as rust nor such materials as are attacked by the drug liquid and dissolved or dispersed therein to contaminate the drug liquid. Therefore, the materials which will be employed must be tested in accordance with an ordinary manner by the use of the aimed drug liquid to confirm if they are usable. Typical examples of the materials used in the present invention include SUS 304, SUS 316, Teflon, polypropylene, polyethylene, polyvinyl chloride, SUS 304 and SUS 316 lined with Teflon, and plastics of polypropylene reinforced with fiber. However, the materials acceptable in this invention should be selected in compliance with properties of the used drug liquid, and it is definite that these materials do not limit the present invention at all.

**Claims**

1. A method for feeding a drug liquid (20) from a hermetic drug liquid returnable can (10) to a drug liquid treatment process by the use of a liquid surface-pressurizing means, wherein a monitor tank (50) is disposed between said drug liquid returnable can (10) and a device (1) for carrying out said drug liquid treatment, wherein the drug liquid (20) is introduced from said drug liquid returnable can into said monitor tank (50) and stored therein, and wherein the drug liquid is fed to said device while always monitoring a level position of the drug liquid in said monitor tank characterized by the steps of equipping the said monitor tank (50) with said liquid surface-pressurizing means; detecting (80) the level of the drug liquid in said monitor tank, when it is below a predetermined position, whereby it is warned that said drug liquid returnable can (10) is empty; and accomplishing the cut-off of the connection (64) between said drug liquid returnable can (10) and said monitor tank (50) as well as the introduciton (61) of a liquid surface-pressurizing gas into said monitor tank in order to continue to feed the drug liquid from said monitor tank to said device and to thereby permit exchanging said empty drug liquid returnable cfan for a new full returnable can during said feeding.

2. The method for feeding a drug liquid from a hermetic drug liquid returnable can according to Claim 1 wherein said method comprises the steps of detecting (80) the lowered level of the drug liquid in said monitor tank (50); on the basis of this detection, carrying out the stop of the introduction (61) of the liquid surface-pressurizing gas into said drug liquid returnable can and the stop (63) of discharging the gas from said monitor tank in order to permit feeding the drug liquid to said monitor tank; after the exchange for a new drug liquid returnable can has been completed, accomplishing the release of the cut-off of the connection (64) between said drug liquid returnable can (10) and said monitor tank (50), the introduction (61) of the liquid surface-pressurizing gas into said returnable can, the stop (64) of introducing the liquid surface-pressurizing gas into said monitor tank, and the discharge (63) of the gas from said monitor tank; and stopping the discharge of the gas from said monitor tank, when the level of the drug liquid in said monitor tank reaches a predetermined position or above.

3. An apparatus for feeding a drug liquid from a hermetic drug liquid returnable can, comprising said hermetic drug liquid returnable can (10) equipped with a member (12) for introducing a liquid surface-pressurizing gas thereinto and a member (11) for transporting the drug liquid therethrough; a monitor tank (50) which is disposed between said drug liquid returnable can and a device (1) for carrying out a drug liquid treatment and which temporarily stores the drug liquid and then feeds it to said device, characterized in that it comprises a means (70, 90), for introducing and discharging the liquid surface-pressurizing gas connected to said monitor tank and a level gauge (80) for monitoring always the level of the drug liquid in the monitor tank and for detecting the lowered level of the drug liquid in order to give warning and to thus permit the switching operation of valves (61, 64) situated in pipes connecting the returnable can (10) and the monitor tank (50).

**Patentansprüche**

1. Verfahren zum Speisen einer Arzneimittelflüssigkeit (20) aus einem hermetischen, wiederverwendbaren Arzneimittel-Flüssigkeitsbehälter (10) zun einem Arzneimittelflüssigkeits-Behandlungsverfahren unter Verwendung einer die Flüssigkeitsoberfläche unter Druck setzenden Vorrichtung, wobei ein Monitortank (50) zwischen dem wiederverwendbaren Arzneimittel-Flüssigkeitsbehälter (10) und einer Vorrichtung (1) zum Durchführen der Arzneimittelflüssigkeits-Behandlung angeordnet ist, wobei die Arzneimittel-Flüssigkeit (20) aus dem wiederverwendbaren Arzneimittel-Flüssigkeitsbehälter in den Monitortank (50) eingespeist und darin gespeichert wird und wobei die Arzneimittelflüssigkeit zu der Vorrichtung unter ständigem Beobachten des Niveaus der Arzneimittelflüssigkeit in den Monitortank gespeist wird, gekennzeichnet durch die Schritte des Ausstattens des Monitortanks (50) mit der Vorrichtung zum Unterdrucksetzen der Flüssigkeitsoberfläche; Erfassen (80) des Niveaus der Arzneimittelflüssigkeit in dem Monitortank, wenn dieses unter ein vorbestimmtes Niveau absinkt, wodurch eine Warnung ausgelöst wird, daß der wiederverwendbare Arzneimittel-Flüssigkeitsbehälter (10) leer ist; und Bewerkstelligen der Unterbrechung der Verbindung (64) zwischen dem wiederverwendbaren Arzneimittel-Flüssigkeitsbehälter (10) und dem Monitortank (50) sowie des Einführens (61) eines die Flüssigkeitsoberfläche unter Druck setzenden Gases in dem Monitortank, um die Speisung der Arzneimittelflüssigkeit aus dem Monitortank in die Vorrichtung fortzusetzen und dadurch einen Ausstausch des leeren, wiederverwendbaren Arzneimittel-Flüssigkeitsbehälters gegen einen neuen, gefüllten wiederverwendbaren Behälter während der genannten Speisung zu ermöglichen.

2. Verfahren zum Speisen einer Arzneimittelflüssigkeit aus einem hermetischen, wiederverwendbaren Arzneimittel-Flüssighkeitsbehälter nach Anspruch 1, wobei das Verfahren die folgenden Schritte umfaßt: Erfassen (80) des abgesunkenen Niveaus der Arzneimittelflüssigkeit in dem Monitortank (50); basierend auf dieser Erfassung: Anhalten des Einführens (61) des die Flüssigkeitsoberfläche unter Druck setzenden Gases in den wiederverwendbaren Arzneimittel-Flüssigkeitsbehälter und Anhalten (63) des Abblasens von Gas aus dem Monitortank zum Ermöglichen eines Speisens der Arzneimittelflüssigkeit in den Monitortank; nach dem Austausch eines neuen, wiederverwendbaren Arzneimittel-Flüssigkeitsbehälters: Veranlassen der Freigabe der Unterbrechung der Verbindung (64) zwischen dem wiederverwendbaren Arzneimittel-Flüssigkeitsbehälter (10) und dem Monitortank (50), des Einführens (61) des die Flüssigkeitsoberfläche unter Druck setzenden Gases in den wiederverwendbaren Behälter, des Anhaltens (64) der Speisung des die Flüssigkeitsoberfläche unter Druck setzenden Gases in den Monitortank und des Abblasens (63) des Gases aus dem Monitortank; und Anhalten des Abblasens des Gases aus dem Monitortank, wenn das Niveau der Arzneimittelflüssigkeit in dem Monitortank ein vorbestimmtes Niveau oder ein darüberliegendes Niveau erreicht.

3. Vorrichtung zum Speisen einer Arzneimittelflüssigkeit aus einem hermetischen, wiederverwendbaren Arzneimittel-Flüssighkeitsbehälter, umfassend: den besagten hermetischen, wiederverwendbaren Arzneimittel-Flüssigkeitsbehälter (10), der mit einer Baugruppe (12) zum Einspeisen eines die Flüssigkeitsoberfläche unter Druck setzenden Gases und einer Baugruppe (1) zum Transportieren der Arzneimittelflüssigkeit in dem Behälter vorgesehen ist; einen Monitortank (50), der zwischen dem wiederverwendbaren Arzneimittel-Flüssigkeitsbehälter und einer Vorrichtung zum Durchführen einer Arzneimittel-Flüssigkeitsbehandlung angeordnet ist und zeitweilig die Arzneimittelflüssigkeit speichert und diese dann in die Vorrichtung einspeist, dadurch gekennzeichnet, daß Mittel (70, 90) zum Einführen und Abblasen des die Flüssigkeitsoberfläche unter Druck setzenden Gases mit dem Monitortank verbunden sind und eine Niveaumevorrichtung (80) zum ständigen Überwachen des Niveaus der Arzneimittelflüssigkeit im Monitortank und zum Erfassen des abgesunkenen Niveaus der Arzneimittelflüssigkeit vorgesehen ist, um eine Warnung abzugeben und somit Ventile (61, 64) zu schalten, die in den wiederverwendbaren Behälter (10) und den Monitortank (50) verbindenden Rohrleitungen angeordnet sind.

## Revendications

1. Procédé pour alimenter en liquide de dopage (20) à partir d'un fût (10) consigné hermétique de liquide de dopage, un procédé de traitement avec liquide de dopage en utilisant des moyens de mise en pression d'une surface liquide, dans lequel un réservoir de contrôle (50) est placé entre ce fût (10) consigné de liquide de dopage (20) et un dispositif (1) pour réaliser ce traitement avec liquide de dopage, dans lequel le liquide de dopage (20) est introduit à partir du fût consigné de liquide de dopage dans le réservoir de contrôle (50) et y est conservé, et dans lequel le liquide de dopage est introduit dans ce dispositif, tout en contrôlant toujours une position du niveau du liquide de dopage dans ce réservoir de contrôle, caractérisé par les étapes d'équipement de ce réservoir de contrôle (50) avec ces moyens de mise en pression de la surface de liquide, de détection (80) du niveau du liquide de dopage dans ce réservoir de contrôle quand il est en dessous d'une position prédéterminée, en sorte qu'il y ait une alarme avertissant que le fût consigné de liquide de dopage est vide; et de réalisation de l'interruption de la liaison (64) entre ce fût consigné (10) de liquide de dopage et ce réservoir de contrôle (50) aussi bien que d'introduction (61) d'un gaz de mise en pression de la surface du liquide dans le réservoir de contrôle en vue de continuer d'alimenter le liquide de dopage depuis ce réservoir de contrôle vers ce dispositif et de permettre ainsi le remplacement du fût consigné de liquide de dopage par un nouveau fût consigné plein pendant cete alimentation.

2. Procédé pour alimenter en liquide de dopage à partir d'un fût consigné hermétique de liquide de dopage selon la revendication 1 dans lequel ce procédé comprend les étapes de détection (80) d'un niveau inférieur de liquide de dopage dans ce réservoir de contrôle (50); à partir de cette détection, réalisation de l'arrêt de l'introduction (61) du gaz mettant en pression la surface du liquide dans ce fût consigné de liquide de dopage et l'arrêt (63) de l'évacuation du gaz hors de ce réservoir de contrôle en vue de permettre l'alimentation de ce réservoir de contrôle en liquide de dopage; après avoir réalisé l'échange par un nouveau fût consigné de liquide de dopage, réalisation de la suppression de l'interruption de la liaison (64) entre ce fût (10) consigné de liquide de dopage et ce réservoir de contrôle (50), l'introduction (61) du gaz mettant en pression la surface du liquide dans ce fût consigné, l'arrêt (64) de l'introduction du gaz mettant en pression la surface du liquide dans ce réservoir de contrôle, et l'évacuation (63) du gaz hors de ce réservoir de contrôle; et l'arrêt de l'évacuation de ce gaz hors de ce réservoir de contrôle, quand le niveau du liquide de dopage dans ce réservoir de contrôle atteint une position prédéterminée ou la dépasse.

3. Appareil pour alimenter en un liquide de dopage à partir d'un fût consigné hermétique de liquide de dopage, comprenant ce fût (10) consigné hermétique de liquide de dopage, équipé d'un membre (12) pour y introduire un gaz de pressurisation de la surface liquide et un membre (11) pour y permettre le transfert du liquide de dopage; un réservoir de contrôle (50) qui est disposé entre ce fût consigné de liquide de dopage et un dispositif (1) pour réaliser un traitement avec liquide de dopage et qui stocke temporairement le liquide de dopage et ensuite le distribue à ce dispositif, caractérisé en ce qu'il comprend des moyens (70, 90), pour introduire et évacuer le gaz mettant en pression la surface du liquide, relié à ce réservoir de contrôle et une jauge de niveau (80) pour toujours contrôler le niveau de liquide dans le réservoir de contrôle et pour détecter le niveau inférieur du liquide de dopage en vue de donner une alarme et de permettre ainsi l'opération de commande des vannes (61, 64), situées sur des tuyaux reliant le fût consigné (10) et le réservoir de contrôle (50).

FIG. 1

FIG. 2

FIG. 3

# FIG.4

# FIG.5

# FIG.6

0 138 718

FIG.7

FIG.8

FIG.9

FIG.10

3